# EUROPEAN PATENT SPECIFICATION

(11) **EP 1 532 289 B1**
(45) Date of publication and mention of the grant of the patent: **07.06.2006**
(21) Application number: 03765267.4
(22) Date of filing: 18.07.2003
(51) Int. Cl.: C23C 16/18, C23C 16/06

(54) **ZIRCONIUM COMPLEX USED FOR THE CVD METHOD AND PREPARATION METHOD OF A THIN FILM USING THEREOF**
ZIRCONIUM KLOMPLEX FÜR DIE CVD-METHODE UND HERSTELLUNGSVERFAHREN FÜR EINEN DÜNNEN FILM
COMPLEXE DE ZIRCONIUM UTILISE DANS LE PROCEDE CVD ET PROCEDE DE PREPARATION D'UN FILM MINCE CONTENANT CELUI-CI

(30) Priority: 22.07.2002 JP 2002244354
(43) Date of publication of application: 25.05.2005
(73) Proprietor: SAES GETTERS S.p.A., 20020 Lainate (Milano) (IT); Toshima MFG. Co. Ltd., Higashimatsuyama-shi, Saitama 355-0036 (JP)
(72) Inventor: KOJI, Yoda, Higashi-matsuyama-shi, Saitama (JP); YUZO, Tasaki, Hachiouji-shi, Tokyo (JP)
(74) Representative: Adorno, Silvano
(86) International application number: PCT/IT2003/000445
(87) International publication number: WO 2004/009867

(56) References cited:
- WO-A-98/51837
- JP-A- 2002 030 025
- JP-A- 2002 053 960
- JP-A- 2002 069 641
- JP-A- 2002 249 456
- US-A1- 2001 022 148
- US-A1- 2002 012 819
- US-B1- 6 376 692

## Description

### TECHNICAL FIELD

The present invention relates to a precursor and a precursor solution used for preparation of Zr-containing thin films by the chemical vapor deposition (CVD) method. In particular, the invention is directed to a precursor solution comprising a specific zirconium complex, which enables to obtain a constant composition ratio of Pb-Zr-Ti-type (which comprises lead zirconate titanate and/or lead zirconate; hereinafter collectively referred to as "PZT") films consistently within a wide range of a substrate temperature in carrying out the liquid source CVD method.

### BACKGROUND ART

In preparation of thin films by use of the CVD method, vapor sources of precursors are generally liquid materials at room temperature such as trimethylgallium, a precursor used in the preparation of GaAs thin films; and tetraethoxysilane, a precursor used in the preparation of SiO₂ thin films. In the CVD method, reactant vapors are supplied by bubbling carrier gases through liquid precursors, evaporating the liquid precursors into the reactant vapors and guiding the reactant vapors entrained in the carrier gas into a deposition chamber.

On the other hand, in the case of using a solid material as a precursor, it is impossible to employ the above bubbling method. The sublimation method is necessarily used for the generation of reactant vapors of the solid precursor materials, wherein the supplying rate of the reactant vapors are not stable in the CVD method.

In order to solve the above problems, the liquid source CVD method is developed, in which solid precursor materials are dissolved in organic solvents such as tetrahydrofuran (THF), butyl acetate, toluene, and octane at a specific concentration. The obtained solutions are injected into a vaporizer chamber at a high temperature at a constant injection rate controlled by a liquid flow meter and a constant amount of the reactant vapors can be obtained by vaporizing all of the injected solutions. In these days, the liquid source CVD method is in popular use in the preparation of complex metal oxides thin films, as shown in Japanese patent applications JP-H07-268634 and JP-H11-323558.

Among these complex metal oxides thin films, currently, PZT thin films are mostly researched and developed as capacitor layers for ferroelectric random access memories (FeRAMs). In the preparation of a PZT thin film by the CVD method, the liquid source CVD method is employed since most of precursors are solid.

For example, Japanese patent No. 3054118 shows metal complexes as a CVD precursor used in the preparation of PZT thin films such as:
- lead precursors including lead bis[dipivaloylmethanate] (Pb(DPM)₂), tetraethyl lead (PbEt₄), and triethylneopentyloxy lead (PbEt₃OCH₂C(CH₃)₃);
- zirconium precursors including zirconium tetrakis[dipivaloylmethanate] (Zr(DPM)₄), tetra-tert-butoxy zirconium (Zr(O-t-Bu)₄), and zirconium tetrakis[diisobutyrylmethanate] (Zr(DIBM)₄); and
- titanium precursors including diisopropoxy titanium bis[dipivaloylmethanate] (Ti(O-iso-Pr)₂(DPM)₂), di-tert-butoxytitanium bis[dipivaloylmethanate] (Ti(O-t-Bu)₂(DPM)₂), tetraisopropoxy titanium (Ti(O-iso-Pr)₄), and tetra-tert-butoxytitanium (Ti(O-t-Bu)₄).

In the liquid source CVD method, the composition ratio of the deposited film can be controlled to some extent by varying the mixing ratio of the precursor solutions. However, there are problems that the composition ratio of the film does not necessarily correspond to the supply ratio of the precursor solutions and it changes due to fluctuations in the substrate temperature. As a reason for this, it can be mentioned that precursors have their own thermal decomposition activation energy different from each other, and precursors tend to react mutually in the liquid or vapor phases, and so on.

For the above reason, it is preferable to select precursors having the same thermal decomposition activation energy and the precursors do not react each other. However, the combinations of the CVD precursors used for the preparation of PZT thin films, contemplated in the art, include PbEt₄/Zr(O-t-BU)₄/Ti(O-t-BU)₄; PbEt₃OCH₂C(CH₃)₃/Zr(O-t-BU)₄/Ti(O-iso-Pr)₄; Pb(DPM)₂/Zr(DPM)₄/Ti(O-iso-Pr)₂(DPM)₂; Pb(DPM)₂/Zr(DIBM)₄/Ti(O-iso-Pr)₂(DPM)₂ and the like. These combinations have problems of such as volatility, toxicity, particle forming in a vapor phase and the unstable composition ratio of the film due to fluctuations in the substrate temperature. The only combination used for the production of PZT thin films in the industrial application is the above described Pb(DPM)₂/Zr(DIBM)₄/Ti(O-iso-Pr)₂(DPM)₂. In using the combination of Pb(DPM)₂/Zr(DIBM)₄/Ti(O-iso-Pr)₂(DPM)₂, the range of temperature in which a composition ratio of the film is not affected by the change of the substrate temperature is very narrow. Especially, there is a problem that the substrate temperature has to be controlled to a narrow range because the amount of the deposited zirconium is remarkably affected by the change of the substrate temperature. Accordingly, an improved Zr-containing precursor used for the production of PZT thin films has been desired.

The object of the invention is therefore to provide a zirconium complex capable of overcoming the aforesaid problems. In the preparation of PZT thin films by the liquid source CVD method, using the zirconium complex of the invention not only widens the range of temperature in which the amount of the deposited zirconium is not affected by the change of the substrate temperature but also the substrate temperature range overlaps the range of temperature in which the amounts of the deposited lead and the deposited titanium are not affected and the composition ratio of the deposited film is stable.

### DISCLOSURE OF INVENTION

The inventors have prepared and evaluated many complexes each having a various kind of properties by changing structures of the complexes including some zirconium complexes. Among them, it is found that using zirconium tetrakis[isobutyrylpivaloylmethanate] (hereinafter referred to as "Zr(IBPM)₄") has a wide range of the substrate temperature in which the amount of the deposited zirconium is stable, and that the temperature range overlaps the range of the substrate temperature in which the amounts of the deposited lead derived from Pb(DPM)₂ and the amounts of the deposited titanium derived from Ti(O-iso-Pr)₂(DPM)₂ are stable. Thus the present invention has been completed.

The zirconium complex of the invention, zirconium tetrakis[isobutyrylpivaloymethanate] or Zr (IBPM)₄ is not described in any known prior art references such as patent US 6376692 B1, in which the properties and structure of a different precursor, zirconium isoproxy tris dipivaloymethanate or Zr(OiPr)(dpm)₃ are disclosed. Another metallorganic zirconium precursor is shown in the Japanese patent application JP 2002-069641, where said zirconium precursor has at least four alkyl groups, three with a chain structure comprising 1-8 carbon atoms, independently chosen, and one with a chain structure with 1-4 carbon atoms. International patent application publication WO 98/51837 discloses another Zr complex comprising only one or two β-diketonates groups and 2, 4 or 6 alkyl groups. A zirconium precursor for the growth of zirconium silicate thin films is disclosed in the Japanese application JP 2002-053960, wherein the disclosed zirconium complex is bound with 4 butyl radicals. Another zirconium precursor is described in the publication US 2002/012819, wherein zirconium is bound with three β-diketonates (rather than four) and also with a branched alkyl group having 4 or 5 carbons. A wide class of zirconium, lead and titanium compounds are described in the publication US 2001/0022148, wherein the metal precursor is bound with alkyl groups optionally comprising halogen substituted alkyl groups. Japanese patent application JP 2002-022148 describes the complex Zr(DPM)₂(i-C3H70).

### BRIEF DESCRIPTION OF DRAWINGS

Figure 1 shows a chart obtained by thermogravimetry-differential thermal analysis (TG-DTA) of Zr(IBPM)₄ conducted in the argon atmosphere;
Figure 2 shows a chart obtained by TG-DTA of Zr(IBPM)₄ conducted in the dry air;
Figure 3 (a) shows two DTA curves of Zr(IBPM)₄ obtained in the dry air and in the argon gas. Figure 3 (b) shows relationships between the differential function (dDTA/dT) and the temperature (°C) obtained in the dry air and in the argon gas;
Figure 4 shows a relationship between the metal deposition rates and the substrate temperature in the preparation of PZT thin films by using a combination of Zr(IBPM)₄/Pb(DPM)₂/Ti(O-iso-Pr)₂(DPM)₂ in Example 1;
Figure 5 shows a relationship between the metal deposition rates and the substrate temperature in the preparation of PZT thin films by using a combination of Zr(DIBM)₄/Pb(DPM)₂/Ti(O-iso-Pr)₂(DPM)₂ in Comparative Example 1.

### BEST MODE FOR CARRYING OUT THE INVENTION

Hereinbelow, the present invention is described in detail.

In the invention, Zr(IBPM)₄ is a complex represented by the following formula (I).

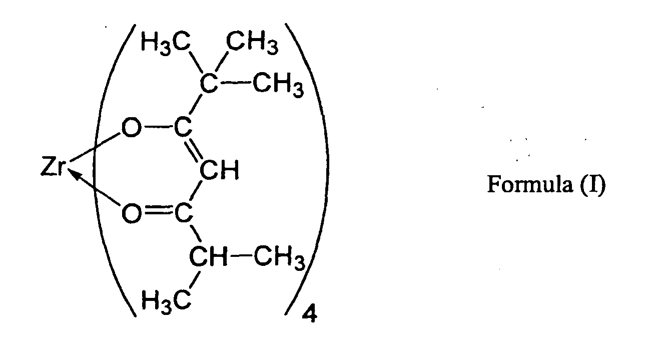

In the present invention, Zr(IBPM)₄ may be prepared by non-limiting example methods such as those described below.
(1) Zirconium chloride (ZrCl₄) and isobutyrylpivaloylmethane ligand (2,2,6-trimethyl-3,5-heptanedione; C₁₀H₁₈O₂) are heated and refluxed in carbon tetrachloride while removing generated hydrogen chloride and the solvent is evaporated under reduced pressure resulting in a crude product;
(2) ZrCl₄ is suspended in toluene and isobutyrylpivatoylmethane is added to the suspension. Then, after further addition of triethylamine and stirring, ZrCl₄ is completely dissolved in the solution and triethylamine chloride (Et₃N • HCl) precipitates in the reaction solution. Then, the reaction solution is filtered and the filtrate is evaporated under reduced pressure resulting in a crude product;
(3) To an ethanol-water (1:1 by weight) solution of zirconyl chloride hydrate (ZrOCl₂ • nH₂O), sodium isobutyrylpivaloylmethanate (NaC₁₀H₁₇O₂) is added and the precipitate is recovered by the suction filtration and dried resulting in a crude product.

The resulting crude product can be recrystallized from ethanol. The Zr content of the refined products are measured by inductively coupled plasma (ICP) spectrometry to obtain 11.9 % by weight which is equal to the theoretical value. The melting point of the refined products is measured by using a melting point apparatus equipped with an oil bath. The refined products do not melt at the highest limit of measurement of 270 °C (visually observed). The solubility in THF, butyl acetate, toluene, octane, and ethylcyclohexane is from 0.33 to 1 mole/liter.

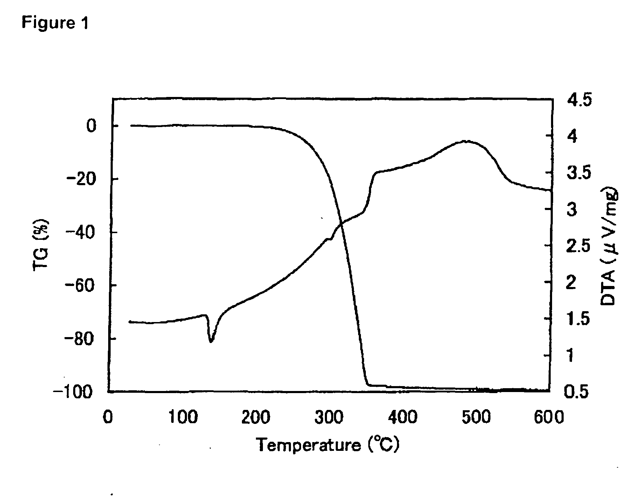

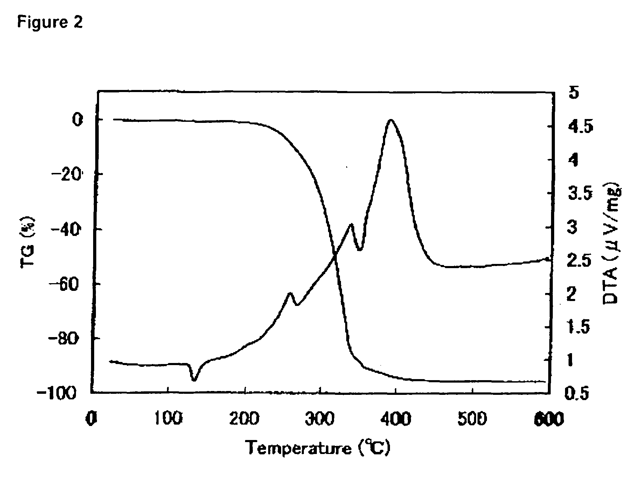

The thermal properties of Zr(IBPM)₄ are shown in Figure 1 and Figure 2 as results of the TG-DTA. In Figure 1, the analysis was conducted in the argon atmosphere. From Figure 1, it can be seen that Zr(IBPM)₄ has an excellent thermal stability.

With respect to the durability in oxidative degradation, precursors having a high oxidative degradation temperature have a problem that, at a substrate temperature of around 580 °C, the oxidative degradation hardly occurs, accordingly Zr hardly contained in the deposited metal flm. Conversely, precursors having a low oxidative degradation temperature have a problem that, at a substrate temperature of around 580 °C, the oxidative degradation easily occurs, accordingly particulate matter generated by the oxidative degradation deteriorates the surface evenness of the substrate and the deposited film.

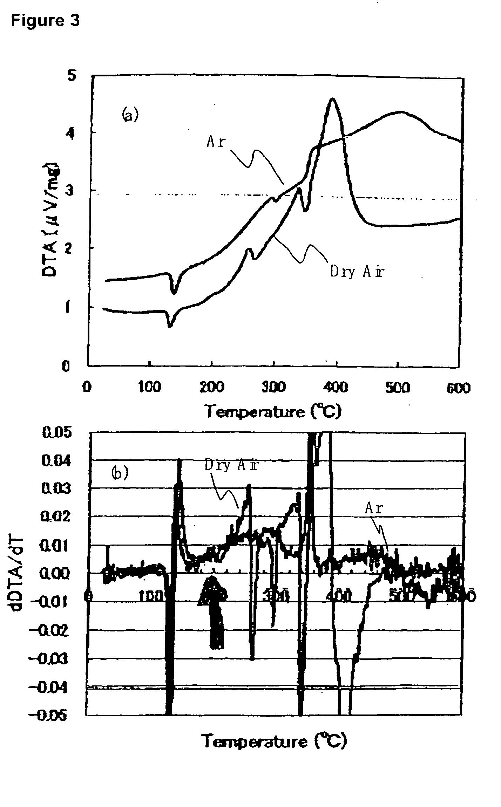

In Figure 2, the measurement was conducted in the dry air. Figure 3(a) shows two DTA curves of Zr(IBPM)₄ obtained in the dry air and in the argon gas. Figure 3(b) shows relationships between the differential function (dDTA/dT) and the temperature (°C) obtained in the dry air and in the argon gas. From Figure 3(b), it can be presumed that the temperature at which the calorific value difference between in the argon gas and in the dry air began to increase was the temperature at which the exothermic oxidation reaction occurred. The temperature at which oxidation reaction occurred was around 180 °C for Zr(IBPM)₄, while around 130 °C for Zr(DIBM)₄ and around 280 °C for Zr(DPM)₄. From the results, it was found that Zr(IBPM)₄ has an excellent durability in oxidative degradation.

When Zr(IBPM)₄ is used as a CVD precursor for the preparation of a film, the liquid source CVD method is preferably employed because the melting point of Zr(IBPM)₄ is higher than 200 °C.

As for the solvent used for Zr(IBPM)₄ as a CVD precursor, preferred are organic solvents which do not react with Zr(IBPM)₄. Non limiting examples include THF, butyl acetate, toluene, octane, ethylcyclohexane and the other solvents which are generally used in the liquid source CVD method. As for the concentration of the Zr(IBPM)₄ solution, preferred is 0.05 to 0.5 mol/1, more preferred is 0.1 to 0.3 mol/litre.

In spite of the above description, the preferable solvents and the preferable range of the concentrations vary dependent on the structures and types of the vaporizer chamber and the deposition chamber of the film preparation apparatus and the types of the CVD methods.

Pb(DPM)₂ is a complex represented by the following formula (II).

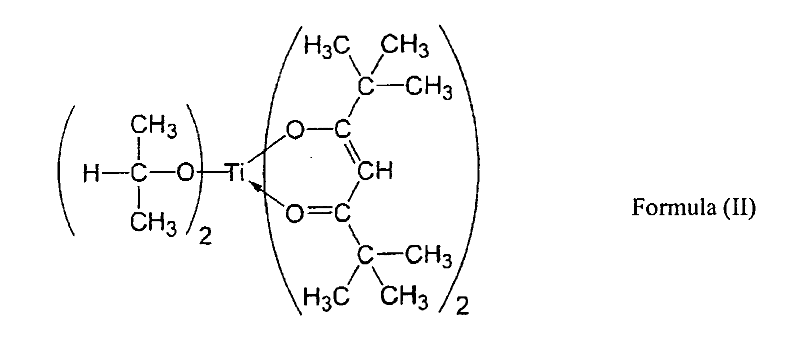

As for the precursor solvent used for Pb(DPM)₂, the above described solvent for Zr(IBPM)₄ can be mentioned. The solvent used for Pb(DPM)₂ can be the same as or different from one used for Zr(IBPM)₄. Also, the concentration of the Zr(IBPM)₄ solution may be 0.05 to 0.5 mol/l, preferably 0.1 to 0.3 mol/litre. The concentration of the Pb(DPM)₂ solution can be the same as or different from one of the Zr(IBPM)₄ solution.

Ti(O-iso-Pr)₂(DPM)₂ is a complex represented by the following formula (III).

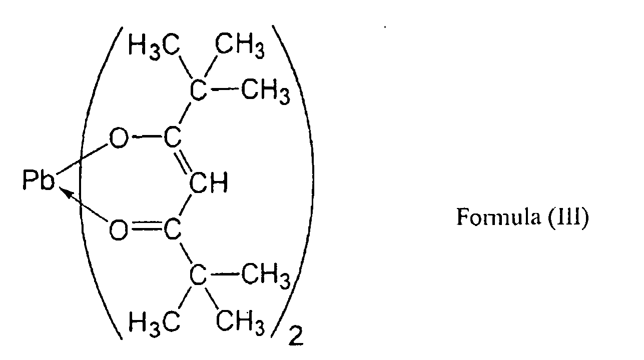

As for the precursor solvent used for Ti(O-iso-Pr)₂(DPM)₂, the above described solvent for Zr(IBPM)₄ can be mentioned. The solvent used for Ti(O-iso-Pr)₂ (DPM)₂ can be the same as or different from either one used for Zr(IBPM)₄ solution or one used for the Pb(DPM)₂ solution. Also, the concentration of the Ti(0-iso-Pr)₂(DPM)₂ solution may be 0.05 to 0.5 mol/l, preferably 0.1 to 0.3 mol/litre. The concentration of the Ti(O-iso-Pr)₂(DPM)₂ solution can be the same as or different from either one of the Zr(IBPM)₄ solution ore one of the Pb(DPM)₂ solution.

In one embodiment of the method of the invention, each of the solution of Zr(IBPM)₄, the solution of Pb(DPM)₂ and the solution of Ti(O-iso-Pr)₂(DPM)₂ is supplied into the vaporizer chamber of the CVD apparatus simultaneously, in order to prepare a PZT thin film. From several preparation of the films changing the substrate temperature, it is found that the deposition rate of Zr on the substrate is stable at a substrate temperature between 460 to 600 °C. Whereas, the deposition rates of Pb and Ti on the substrate are stable at a substrate temperature between 500 to 600 °C and between 520 to 600 °C respectively. Accordingly, a PZT thin film having a constant composition ratio can be obtained consistently by using the Zr complex of the invention.

The range of the substrate temperature in which the PZT thin film having a constant composition ratio can be obtained consistently is generally from 500 to 630 °C, preferably from 520 to 600 °C, more preferably from 550 to 600 °C.

In the method of the invention, the range of temperature in which the constant composition ratio of the film can be obtained consistently is broad. Consequently, in the invention, it is not necessary to control the substrate temperature tightly.

In general, the recrystallization annealing of PZT thin films prepared by the CVD method is conducted so as to impart electrical properties such as hysteresis (ferroelectricity). In the annealing treatment, films are heated at 550 °C or more for 10 to 60 minutes. In the present invention, PZT thin films having excellent electrical properties can be obtained with not use of the annealing treatment.

Further, in the range of the substrate temperature, there is an advantage in that a crystallized PZT thin film can be obtained without thermal treatment (annealing) after the film preparation.

In the scope of the invention, the similar effects can be obtained even if a slight amount of elements except Pb, Zr and Ti are added into PZT films.

In the invention, the three solutions of the above Zr(IBPM)₄, Pb(DPM)₂ and Ti(O-iso-Pr)₂(DPM)₂ may be mixed previously before the vaporization. Also, the above Zr(IBPM)₄, Pb(DPM)₂ and Ti(O-iso-Pr)₂(DPM)₂ may be dissolved in one solution. However, it is may be necessary to conduct the CVD process immediately after mixing or dissolving because the replacement of the different ligands of these complexes occurs with the passage of time.

### EXAMPLE 1

Each of Zr(IBPM)₄, Pb(DPM)₂ and Ti(O-iso-Pr)₂(DPM)₂ was dissolved in THF at a concentration of 0.3mol/l to obtain three solutions (a Zr precursor solution, a Pb precursor solution and a Ti precursor solution). These three solutions were supplied into the CVD apparatus simultaneously; under the conditions of a vaporizer temperature of 250 °C, a pressure of 10 torr in the deposition chamber, an oxygen flow rate of 1000 cc/min, and an Ar carrier gas flow rate of 1200cc/min; with feeding rates of a Zr precursor solution at 0.50 ml/min, of a Pb precursor solution at 0.53 ml/min,and of a Ti precursor solution at 0.51 ml/min. The film preparation were carried out on Pt substrates for 10 minutes, with changing the substrate temperature every 20°C within the range of 440 to 640 °C. The amounts of metals (Zr, Pb and Ti) deposited on the substrate were measured by use of ICP spectrometry.

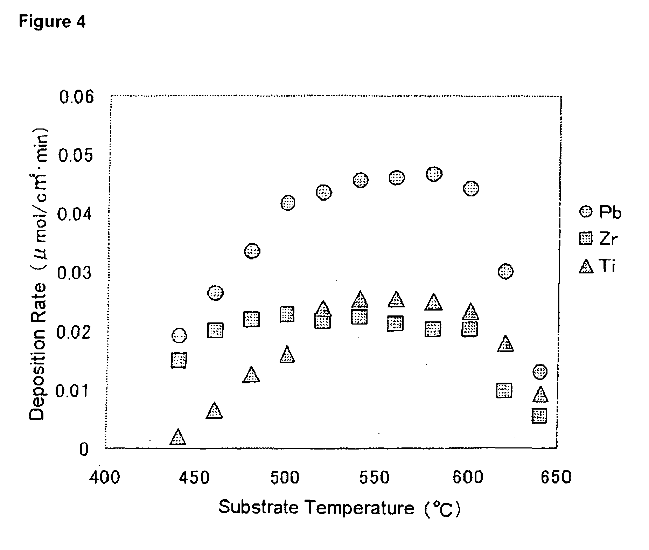

As can be clearly understood from the results of the each metal deposition rate shown in Figure 4, the range of the substrate temperature where the stable Zr deposition rate can be obtained was from 460 to 600 °C, and the ranges where the stable Pb and Ti deposition rates can be obtained were from 500 to 600 °C and from 520 to 600 °C respectively. That is, the substrate temperature where a constant composition ratio of the PZT film can be obtained stably was in the range between 520 to 600 °C.

### COMPARATIVE EXAMPLE 1

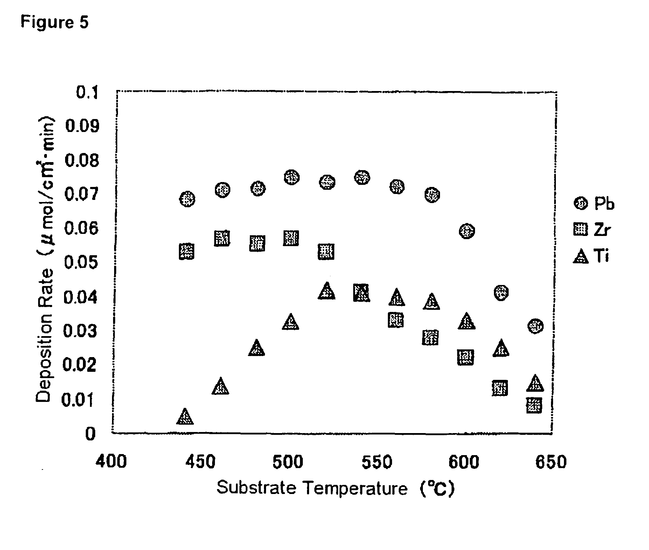

A PZT thin film was prepared in the same manner as in Example 1 with the exception that Zr(DIBM)₄ was substituted for Zr(IBPM)₄. The results of the metal deposition rates of the prepared film were shown in Figure 5.

The range of the substrate temperature where the stable Zr deposition rate can be obtained was from 440 to 520 °C, while the ranges where the stable Pb and Ti deposition rates can be obtained were from 440 to 580 °C and from 520 to 580 °C respectively. That is, the substrate temperature where a constant composition ratio of the PZT film can not be obtained in Comparative Example 1. In other words, in Comparative Example 1, so as to obtain a constant composition ratio of the film, it was necessary to control the substrate temperature tightly, for example precisely at 520 °C.

### INDUSTRIAL APPLICABILITY

From the above, in the preparation of a PZT thin film by the liquid source CVD method, using Zr(IBPM)₄ of the invention as a zirconium precursor enables to obtain a constant composition ratio of films within a wide range of the substrate temperature, and negates the need for the thermal treatment after the film preparation. Therefore, the present invention provides a PZT thin film having a constant quality at a low cost.

## Claims

1. Zirconium tetrakis(isobutyrylpivaloylmethanate) complex used for preparation of a Zr containing thin film by the CVD method.

2. A composition comprising zirconium complex according to claim 1, used for preparation of a Pb-Zr-Ti-type thin film by the CVD method.

3. The composition according to claim 2, which is a precursor solution used for preparation of a Pb-Zr-Ti-type thin film by the liquid source CVD method.

4. . A preparation method of a Zr containing thin film by the liquid source CVD method **characterized by** using a precursor solution comprising zirconium tetrakis(isobutyrlpivaloylmethanate) complex.

5. The preparation method according to claim 4, wherein a precursor solution comprising diisopropoxy titanium bis(dipivaloylmethanate) complex is used with the precursor solution comprising zirconium tetrakis(isobutyrlpivaloylmethanate) complex.

6. The preparation method according to claim 4 or 5, wherein a precursor solution comprising lead bis(dipivaloylmethanate) complex is used with the precursor solution comprising zirconium tetrakis(isobutyrylpivaloylmethanate) complex.

7. The preparation method according to claim 5 or 6, wherein a composition ratio is stable at a substrate temperature between 500 °C and 600 °C.

## Patentansprüche

1. Zirconium-tetrakis(isobutyrylpivaloylmethanat)-Komplex, der zur Herstellung einer Zr enthaltenden dünnen Schicht durch das CVD-Verfahren verwendet wird.

2. Zusammensetzung, die den Zirconiumkomplex nach Anspruch 1 umfasst und zur Herstellung einer dünnen Schicht vom Typ Pb-Zr-Ti durch das CVD-Verfahren verwendet wird.

3. Zusammensetzung nach Anspruch 2, welche eine Vorläuferlösung ist, die zur Herstellung einer dünnen Schicht vom Typ Pb-Zr-Ti durch das CVD-Verfahren mit einer flüssigen Quelle verwendet wird.

4. Verfahren zur Herstellung einer Zr enthaltenden dünnen Schicht durch das CVD-Verfahren mit einer flüssigen Quelle, **gekennzeichnet durch** die Verwendung einer Vorläuferlösung, die den Zirconium-*tetrakis*(isobutyrylpivaloylmethanat)-Komplex enthält.

5. Herstellungsverfahren nach Anspruch 4, in welchem eine Vorläuferlösung, die den Diisopropoxytitanbis(dipivaloylmethanat)-Komplex enthält, zusammen mit der Vorläuferlösung, die den Zirconium-*tetrakis*(isobutyrylpivaloylmethanat)-Komplex enthält, verwendet wird.

6. Herstellungsverfahren nach Anspruch 4 oder 5, in welchem eine Vorläuferlösung, die den Bleibis(dipivaloylmethanat)-Komplex enthält, zusammen mit der Vorläuferlösung, die den Zirconium*tetrakis*(isobutyrylpivaloylmethanat)-Komplex enthält, verwendet wird.

7. Herstellungsverfahren nach Anspruch 5 oder 6, in welchem das Zusammensetzungsverhältnis bei einer Substrattemperatur von zwischen 500 und 600 °C stabil ist.

## Revendications

1. Complexe de tétrakis(isobutyrylpivaloylméthanate) de zirconium utilisé pour la préparation d'un film mince contenant Zr par le procédé CVD.

2. Composition comportant un complexe de zirconium selon la revendication 1, utilisée pour la préparation d'un film mince de type Pb-Zr-Ti par le procédé CVD.

3. Composition selon la revendication 2, qui est une solution précurseur utilisée pour la préparation d'un film mince de type Pb-Zr-Ti par le procédé CVD à source liquide.

4. Procédé de préparation d'un film mince contenant Zr par le procédé CVD à source liquide **caractérisé en ce qu'**il utilise une solution précurseur comportant un complexe de tétrakis(isobutyrylpivaloylméthanate) de zirconium.

5. Procédé de préparation selon la revendication 4, dans lequel une solution précurseur comportant un complexe de bis(dipivaloylméthanate) de diisopropoxytitane est utilisée avec la solution précurseur comportant un complexe de tétrakis(isobutyrylpivaloylméthanate) de zirconium.

6. Procédé de préparation selon la revendication 4 ou 5, dans lequel une solution précurseur comportant un complexe de bis(dipivaloylméthanate) de plomb est utilisée avec la solution précurseur comportant un complexe de tétrakis(isobutyrylpivaloylméthanate) de zirconium.

7. Procédé de préparation selon la revendication 5 ou 6, dans lequel un rapport de composition est stable à une température de substrat comprise entre 500°C et 600°C.
